(19) Europäisches Patentamt
European Patent Office
Office européen des brevets

(11) Numéro de publication: **0 228 945 B1**

(12) **FASCICULE DE BREVET EUROPEEN**

(45) Date de publication de fascicule du brevet: **22.05.91**

(51) Int. Cl.5: **G01R 31/28**, G01R 31/26, H01L 27/14

(21) Numéro de dépôt: **86402726.3**

(22) Date de dépôt: **09.12.86**

# (54) Procédé de test d'une plaquette de traitement à circuits d'entrée à injection directe et plaquette de traitement agencée pour ce test.

(30) Priorité: **10.12.85 FR 8518237**

(43) Date de publication de la demande: **15.07.87 Bulletin 87/29**

(45) Mention de la délivrance du brevet: **22.05.91 Bulletin 91/21**

(84) Etats contractants désignés: **BE DE GB NL SE**

(56) Documents cités:
**DE-A- 2 944 148**
**GB-A- 2 058 366**

**SOLID STATE DEVICES, 1982-ESSDERC-SSSDT, Munich, 13-16 septembre 1982, pages 175-201, Physik-Verlag, Weinheim, DE; C.T. ELLIOTT: "Infrared detectors with integrated signal processing"**

(73) Titulaire: **SAT Société Anonyme de Télécommunications**
**41, rue Cantagrel**
**F-75631 Paris Cedex 13(FR)**

(72) Inventeur: **Sirieix, Michel Benoît**
**11 parc de Diane**
**F-78350 Jouy en Josas(FR)**
Inventeur: **Pruvot, Henri Guy Gaston**
**86 avenue Emile Zola**
**F-75015 Paris(FR)**
Inventeur: **Virdis, Albin**
**7 rue de Viry**
**F-91600 Savigny sur Orge(FR)**

(74) Mandataire: **Bloch, Gérard et al**
**2, square de l'Avenue du Bois**
**F-75116 Paris(FR)**

EP 0 228 945 B1

Il est rappelé que: Dans un délai de neuf mois à compter de la date de publication de la mention de la délivrance du brevet européen, toute personne peut faire opposition au brevet européen délivré, auprès de l'Office européen des brevets. L'opposition doit être formée par écrit et motivée. Elle n'est réputée formée qu'après paiement de la taxe d'opposition (art. 99(1) Convention sur le brevet européen).

## Description

La présente invention concerne un procédé de vérification du bon fonctionnement, ou de test, d'une plaquette de traitement des courants de sortie de diodes d'une plaquette de détection, ainsi que la plaquette de traitement agencée pour ce test.

Si on considère, par exemple, la plaquette de détection d'une caméra thermique pour analyse de paysages en temps réel, cette plaquette contient une mosaïque de plusieurs centaines, voire d'un millier, de photodiodes infrarouge : elle est donc d'un prix de revient très élevé. Cette plaquette de détection est à superposer sur une plaquette de traitement, généralement en silicium semi-conducteur, dans lequel sont intégrés des circuits de traitement à transfert de charges, et chaque diode de détection est à connecter à un circuit d'entrée de la plaquette de traitement à l'aide d'une connexion par exemple du type "poutre" (beam-lead). La superposition et l'interconnexion des deux plaquettes constituent ce qu'on appelle l'hybridation.

Il va de soi qu'avant de procéder à une telle hybridation, il est préférable de s'assurer du bon fonctionnement de la plaquette de traitement qu'il convient donc de tester.

Car si le test était réalisé après hybridation, et s'il s'avérait négatif, non seulement la plaquette de traitement serait à écarter mais la plaquette de détection également. Or cette dernière, rappelons le, coûte cher.

La présente invention concerne plus particulièrement les plaquettes de traitement à circuits d'entrée à injection directe, comprenant, par exemple, un transistor d'entrée à effet de champ FET (field effect transistor).

Il est exclu de vouloir tester un à un tous les circuits d'entrée, par injection d'un signal à l'entrée de chacun des circuits d'entrée et donc par connexion multiple de tous ces circuits d'entrée.

Après hybridation, le problème serait simple à résoudre, mais avec le risque de perdre la plaquette de détection, on l'a déjà dit. Il suffirait de ne pas refroidir les détecteurs, qui ne seraient plus alors semi-conducteurs et constitueraient des courts-circuits, et de relier les substrats des plaquettes de traitement et de détection par l'intermédiaire d'un générateur de tension.

La présente invention vise donc à résoudre le problème de la mise en oeuvre du test d'une plaquette de traitement à circuits d'entrée à injection directe comprenant une pluralité de transistors à effet de champ.

A cet effet, la présente invention concerne un procédé de test d'une plaquette de traitement à circuits d'entrée à injection directe comprenant une pluralité de transistors d'entrée à effet de champ en parallèle, à associer à une pluralité de photodiodes infrarouge correspondantes d'une plaquette de détection, caractérisé par le fait qu'on injecte des courants dans les transistors d'entrée à l'aide d'une pluralité de transistors de test, on polarise les transistors de test et les transistors d'entrée de manière que la différence entre les potentiels de la grille et de la source des transistors d'entrée soit légèrement inférieure à leur tension de seuil, on mesure la dispersion des tensions de seuil respectives des transistors d'entrée et on la compare à un gradient de seuils tolérable.

Les plaquettes présentant une dispersion de tensions de seuil égale ou supérieure au gradient maximal tolérable sont donc, grâce au procédé de l'invention, considérées comme rebut.

De préférence, on intègre les courants de sortie des transistors d'entrée pour obtenir des quantités de charges qu'on multiplexe, qu'on convertit en potentiels et qu'on convertit logarithmiquement, on mesure et on isole la plus grande et la plus petite de ces quantités de charges, et on en fait la différence.

L'invention concerne également une plaquette de traitement à circuits d'entrée à injection directe comprenant une pluralité de transistors d'entrée à effet de champ en parallèle, à associer à une pluralité de photodiodes infrarouge d'une plaquette de détection, et agencée pour la mise en oeuvre du procédé de test de l'invention, caractérisée par le fait qu'une deuxième pluralité de transistors de test à effet de champ sont connectés en série avec les transistors d'entrée, respectivement, les drains des transistors de test étant confondus avec les sources des transistors d'entrée, les sources, d'une part, et les grilles de polarisation, d'autre part, des transistors de test étant réunies entre elles, respectivement.

Ainsi, les transistors de test peuvent se comporter comme des générateurs de courant pour les transistors d'entrée.

Avantageusement, les transistors de test et d'entrée sont implantés sur un substrat silicium, les uns à côté des autres, respectivement, la diode de sortie des transistors de test étant la diode d'entrée des transistors d'entrée, agencée pour être connectée à la photodiode correspondante de la plaquette de détection.

L'invention sera mieux comprise à l'aide de la description suivante de la plaquette de traitement et du procédé de test de l'invention, en référence aux dessins annexés, sur lesquels

- la figure 1 représente schématiquement un transistor à effet de champ;
- la figure 2 représente le schéma électrique du transistor de la figure 1;
- la figure 3 représente schématiquement la

plaquette de traitement agencée selon l'invention, avec le schéma électrique des barrettes de transistors de test et d'entrée, et

- la figure 4 représente schématiquement l'implantation des transistors de test et d'entrée de la plaquette de traitement de l'invention.

Rappelons brièvement d'abord ce qu'est un transistor à effet de champ FET (field effect transistor) à structure MOS (metal oxyd semi-conductor), représenté sur la figure 1 et, par son schéma électrique, sur la figure 2.

Un substrat 1, d'un type de conductivité, comporte deux zones 2 de dopage, de l'autre type de conductivité, diffusées à partir de deux ouvertures pratiquées dans une couche d'oxyde 3. Deux bornes de contact 4 connectées aux deux zones de dopage 2 constituent le drain et la source. Une couche métallique 5, sur la couche d'oxyde entre les deux ouvertures de dopage, constituant la grille de polarisation, et connectée à une troisième borne de contact, assure la polarisation du transistor. Quand la grille 5 est sous tension, il se crée sous celle-ci une charge d'espace qui comble en porteurs minoritaires l'espace s'étendant entre les deux zones de dopage 2 et qui connecte la source et le drain 4, 4. C'est dans cette technologie qu'est réalisée la forme préférée de la plaquette de traitement de l'invention, dont tous les circuits et composants sont intégrés sur un substrat en silicium semi-conducteur.

Un transistor à effet de champ FET ne devient passant qu'à partir d'une différence, entre la tension grille $V_g$ et la tension source $V_e$, déterminée. Cette différence de tension est appelée tension de seuil $V_S$. Tant que $V_g$-$V_e$ est inférieure à $V_S$, il ne passe en théorie, aucun courant dans le transistor. En fait, si on applique à la source d'un transistor FET une tension $V_e$ telle que $V_g$-$V_e$ soit très légèrement inférieure à $V_S$ et égale à $V_S- \epsilon$, il passe quand même un courant faible I, dont l'amplitude est proportionnelle à $e^{-\epsilon}$, le nombre e étant la base du logarithme népérien, $I = Ke^{-\epsilon}$.

L'intégration de ce courant sur une période T fournit une quantité de charges Q

$$Q = kTe^{-\epsilon}$$

Cette quantité de charges Q et la tension de sortie $V_o$ sont égales, à une grandeur capacitive C près

$$V_o = \frac{Q}{C}$$

$$V_o = \frac{kT}{C}e^{-\varepsilon}$$

$$V_o = Ke^{-\varepsilon}$$

Après conversion logarithmique, la tension de sortie est donc proportionnelle à $-\epsilon$.

En outre, il faut ici souligner la relation $\epsilon = V_S - (V_g - V_e)$.

Dans ces conditions, et pour son test avant hybridation, on agence la plaquette de traitement de la manière décrite ci-dessous.

En référence tout d'abord au schéma électrique de la figure 3, la plaquette de traitement 10 de l'invention comporte une pluralité, ou une barrette, de transistors d'entrée à effet de champ 11 en parallèle, connectés respectivement à une pluralité de plots d'accès 12 par leurs sources 13. C'est à ces plots 12 que seront ultérieurement reliées des connexions de la plaquette 10 et d'une plaquette de photodiodes infrarouge de détection. A une photodiode de détection sera donc associé un transistor d'entrée 11. Les grilles de polarisation 18 des transistors d'entrée sont reliées entre elles et connectées à un plot d'accès 19.

En série avec les transistors d'entrée 11 sont implantés une pluralité, ou une barrette, de transistors de test 20 à effet de champ, en nombre égal, dont les drains sont confondus avec les sources 13 des transistors d'entrée. Les sources 14 des transistors de test 20 sont réunies entre elles et connectées à un plot d'accès 15. Il en est de même des grilles 16 des transistors de test 20, qui sont réunies entre elles et connectées à un autre plot d'accès 17.

Chaque transistor d'entrée 11 est suivi d'un circuit qui comporte un intégrateur 21, connecté au drain 22 du transistor 11, d'un côté, et à un multiplexeur 23, de l'autre côté. Le multiplexeur 23 reçoit les informations de sortie de tous les intégrateurs 21.

Pour tester la plaquette 10 dans son ensemble ainsi défini, et en particulier les transistors d'entrée 11, on met sous tension les sources et les grilles des transistors de test 20, par les plots 15 et 17, respectivement, pour qu'ils fonctionnent en régime de saturation. Dans ces conditions, où la différence entre les potentiels grille et source est beaucoup plus grande que leur tension de seuil, ils présentent une très faible résistance, en pratique de l'ordre de quelques kΩ. Les sources 13 des transistors d'entrée 11, qui sont les drains des transistors de test, sont ainsi mises à un même potentiel $V_e$. On

met sous tension les grilles 18 des transistors d'entrée, par le plot 19, à un potentiel commun $V_g$ tel que la différence $V_g$-$V_e$ soit très légèrement inférieure,de $\epsilon$,à leur tension de seuil $V_S$. Il circule dans les transistors d'entrée 11 des courants de l'ordre de quelques nA, si bien que la tension source $V_e$ est de l'ordre de quelques $\mu$V. Même si les tensions source $V_e$ des transistors d'entrée ne sont pas rigoureusement les mêmes, cela est sans importance, puisque la valeur de la dispersion des tensions de seuil ($V_{S\ max}$- $V_{S\ min}$) de ces transistors d'entrée, qu'on veut appréhender, est de l'ordre de quelques mV.

Les courants de sortie des transistors d'entrée 11 sont intégrés dans les intégrateurs 21 et les quantités de charges délivrées en sortie des intégrateurs sont multiplexés dans le multiplexeur 23. Après mesure de toutes les valeurs absolues de quantités de charges $\epsilon$ converties en potentiels et converties dans un convertisseur logarithmique 27, on isole la plus grande $\epsilon_{max}$ et la plus petite $\epsilon_{min}$ de ces quantités de charges dans des tampons 24, 25 montés en parallèle, respectivement, avant de déterminer, dans le soustracteur 26 relié aux sorties des deux tampons, la différence entre ces deux valeurs. Comme les potentiels $V_g$ et $V_e$ sont communs à tous les transistors d'entrée 11, conformément à la relation soulignée plus haut on peut écrire $\epsilon_{max}$ = $V_{Smax}$ - ($V_g$ - $V_e$)et

$\epsilon_{min}$ = $V_{Smin}$ - ($V_g$ - $V_e$).La différence ($\epsilon_{max}$ - $\epsilon_{min}$) est donc égale à la différence entre les tensions de seuil maximale $V_{Smax}$ et minimale $V_{Smin}$, soit la dispersion $V_{Smax}$ - $V_{Smin}$, qu'on compare au gradient maximal tolérable pour garder ou rejeter la plaquette testée.

Abordons maintenant la réalisation concrête, en technologie MOS de la plaquette de l'invention, au niveau seulement des deux barrettes des transistors de test et d'entrée et en ne considérant qu'un seul des circuits de test et d'entrée (figure 4) et la modification apportée par l'invention à la plaquette de la figure 1.

La source 30 du transistor d'entrée, reliée à la diode d'entrée 31 du transistor d'entrée 11 est normalement connectée à la photodiode de détection associée 32. Pour le test, la connexion est rompue, comme représenté sur la figure 4. Le transistor de test 20, associé au transistor d'entrée 11, est implanté à côté du transistor 11, la diode de sortie du transistor 20 étant la diode d'entrée 31 du transistor d'entrée 11. La source 33 du transistor de test 20 est reliée à sa diode d'entrée 34, et une grille de polarisation 35 peut créer une charge d'espace entre les deux diodes 34, 31 du transistor de test 20.

Le transistor de test 20 permet donc, comme un générateur de courant, d'injecter du courant dans les puits de potentiel du transistor d'entrée 11 par l'intermédiaire de la diode d'entrée 31 et de la grille de polarisation 36 du transistor d'entrée 11. Le transistor de test 20 est bien en série avec le transistor d'entrée à tester, par la source de celui-ci, et en parallèle sur la diode de détection destinée à être connectée au transistor d'entrée considéré.

Bien entendu, d'autres composants sont intégrés sur la plaquette de traitement, mais ils ne seront pas ici décrits, car ils n'ont aucun lien avec l'invention.

En ce qui concerne, par ailleurs, le convertisseur quantités de charges - tensions, le convertisseur logarithmique 27, l'élément de mesure, les tampons 24, 25 et le soustracteur 26, montés en série, il s'agit d'éléments de test et de mesure, de structure classique.

## Revendications

1. Procédé de test d'une plaquette de traitement à circuits d'entrée à injection directe comprenant une pluralité de transistors d'entrée à effet de champ (11) en parallèle, à associer à une pluralité de photodiodes infrarouge correspondantes (32) d'une plaquette de détection, caractérisé par le fait qu'on injecte des courants dans les transistors d'entrée (11) à l'aide d'une pluralité de transistors de test (20), on polarise les transistors de test (20) et les transistors d'entrée (11) de manière que la différence entre les potentiels de la grille (18) et de la source (13) des transistors d'entrée (11) soit légèrement inférieure à leur tension de seuil, on mesure la dispersion des tensions de seuil respectives des transistors d'entrée (11) et on la compare à un gradient de seuils tolérables.

2. Procédé de test selon la revendication 1, dans lequel on intègre les courants de sortie des transistors d'entrée (11) pour obtenir des quantités de charges qu'on multiplexe (23), qu'on convertit en potentiels et qu'on convertit logarithmiquement (27), on mesure et on isole (24,25) la plus grande et la plus petite de ces quantités de charges et on en fait la différence (26).

3. Plaquette de traitement à circuits d'entrée à injection directe comprenant une pluralité de transistors d'entrée (11) à effet de champ en parallèle, à associer à une pluralité de photodiodes infrarouge d'une plaquette de détection, et agencée pour la mise en oeuvre du procédé de test selon la revendication 1, caractérisée par le fait qu'une deuxième pluralité de transistors de test (20) à effet de champ sont connectés en série avec les transistors d'entrée (11), respectivement, les drains des transistors de test (20) étant confondus avec les sources (13) des transistors d'entrée (11), les sources (14), d'une part, et les grilles de polarisation (16), d'autre part, des transistors de test (20) étant réunies entre elles, respectivement.

**4.** Plaquette de traitement selon la revendication 3, dans laquelle les transistors de test (20) et d'entrée (11) sont implantés sur un substrat silicium (1), les uns à côté des autres, respectivement, la diode (31) de sortie des transistors de test (20) étant la diode d'entrée des transistors d'entrée (11), agencée pour être connectée à la photodiode correspondante (32) de la plaquette de détection.

**5.** Plaquette de traitement selon l'une des revendications 3 et 4, dans laquelle chaque transistor d'entrée (11) est connecté à un intégrateur (21), raccordé à un multiplexeur (23), commun à tous les intégrateurs (21).

**6.** Plaquette selon la revendication 5, dans laquelle le multiplexeur (23) est relié, en série, à un convertisseur de tension, à un convertisseur logarithmique (27), à un appareil de mesure, à deux tampons (24,25) en parallèle, et à un soustracteur (26) relié aux sorties des deux tampons (24,25).

## Claims

**1.** Method for testing a treatment wafer having input circuits with direct injection, comprising a plurality of field effect input transistors (11) in parallel, to be associated with a plurality of corresponding infrared photodiodes (32) of a detection wafer, characterised by the fact that currents are injected into the input transistors (11) by means of a plurality of test transistors (20), the test transistors (20) and the input transistors (11) are polarized so that the difference between the potentials of the gate (18) and of the source (13) of the input transistors (11) is slightly less than their threshold voltage, the dispersion of the respective threshold voltages of the input transistors (11) is measured and compared with a gradient of tolerable thresholds.

**2.** Test method according to claim 1, in which the output currents of the input transistors (11) are integrated in order to obtain quantities of charges which are multiplexed (23), which are converted into potentials and which are converted logarithmically (27), one measures and isolates (24,25) the largest and smallest of these quantities of charges and one forms the difference (26) therebetween.

**3.** Treatment wafer having input circuits with direct injection comprising a plurality of field effect input transistors (11) in parallel, to be associated with a plurality of infrared photodiodes of a detection wafer, and arranged for carrying out the test method according to claim 1, characterised by the fact that a second plurality of field effect test transistors (20) are connected in series with the input transistors (11), respectively, the drains of the test transistors (20) being combined with the sources (13) of the input transistors (11), the sources (14), on the one hand, and the polarization gates (16), on the other hand, of the test transistors (20) being connected to each other, respectively.

**4.** Treatment wafer according to claim 3, in which the test transistors (20) and input transistors (11) are implanted on a silicon substrate (1), one beside the other, respectively, the output diode (31) of the test transistors (20) being the input diode of the input transistors (11), arranged in order to be connected to the corresponding photodiode (32) of the detection wafer.

**5.** Treatment wafer according to one of claims 3 and 4, in which each input transistor (11) is connected to an integrator (21), connected to a multiplexer (23), common to all the integrators (21).

**6.** Wafer according to claim 5, in which the multiplexer (23) is connected, in series, to a voltage converter, to a logarithmic converter (27), to a measuring apparatus, to two buffers (24,25) in parallel, and to a subtractor (26) connected to the outputs of the two buffers (24,25).

## Ansprüche

**1.** Testverfahren für eine Verarbeitungsplatte mit direkt eingespeisten Eingangskreisen, die eine Vielzahl von parallelen Feldeffekt-Eingangstransistoren (11) umfaßt, die mit einer Vielzahl von entsprechenden infrarot-Fotodioden (32) einer Detektorplatte verbunden sind, dadurch gekennzeichnet, daß Ströme in die Eingangstransistoren (11) mit Hilfe einer Vielzahl von Testtransistoren (20) eingespeist werden, die Testtransistoren (20) und die Eingangstransistoren (11) vorgespannt werden, sodaß die Differenz zwischen den Potentialen der Gateanschlüsse (18) und der Sourceanschlüsse (13) der Eingangstransistoren (11) geringfügig unter ihrer Schwellspannung liegt, die Streuung der jeweiligen Schwellspannungen der Eingangstransistoren (11) gemessen und mit einem Gradienten von zulässigen Schwellen verglichen wird.

2. Testverfahren nach Anspruch 1, in welchem die Ausgangsströme der Eingangstransistoren (11) integriert werden, um Größen von Ladungen zu erhalten, die gemultiplext (23), in Potentiale und logarithmisch (27) umgewandelt werden, und in welchem die größte und die kleinste dieser Ladungsgrößen gemessen und getrennt (24,25) werden, und davon die Differenz (26) gebildet wird.

3. Verarbeitungsplatte mit direkt eingespeisten Eingangskreisen, die eine Vielzahl von parallelen Feldeffekt-Eingangstransistoren (11) umfmaßt, die mit einer Vielzahl von Infrarot-Fotodioden eines Erkennungs Detektorplatte verbunden werden, und die zur Durchführung des Testverfahrens nach Anspruch 1 eingerichtet ist, dadurch gekennzeichnet, daß eine zweite Vielzahl von Feldeffekt - Testtransistoren (20) in Serie mit den Eingangstransistoren (11) verbunden ist, wobei jeweils die Drainanschlüsse der Testtransistoren (20) und Sourceanschlüsse (13) der Eingangstransistoren (11) ineinander verschwimmen und wobei einerseits die Sourceanschlüsse (14) und andererseits die Polarisations-Gateanschlüsse (16) der Testtransistoren (20) jeweils miteinander vereinigt sind.

4. Verarbeitungsplatte nach Anspruch 3, in welcher die Testtransistoren (20) und die Eingangstransistoren (11) auf einem Siliziumsubstrat (1) implantiert sind, die einen jeweils neben den anderen, wobei die Ausgangsdiode (31) der Testtransistoren (20) die Eingangsdiode der Eingangstransistoren (11) ist, und eingerichtet ist, um an die entsprechende Fotodiode (32) des Erkennungs Detektorplatte angeschlossen zu werden.

5. Verarbeitungsplatte nach einem der Ansprüche 3 und 4, in welcher jeder Eingangstransistor (11) an einen Integrator (21), der an einen allen Integratoren (21) gemeinsamen Multiplexer (23) angeschlossen ist, gekoppelt ist.

6. Platte nach Anspruch 5, in welcher der Multiplexer (23) in Serie an einen Spannungsumwandler, an einen logarithmischen Umwandler (27), an eine Meßeinrichtung, an zwei parallele Pufferspeicher (24,25) und an einen an die Ausgänge der zwei Speicher (24,25) geschalteten Subtrahierer (26) geschaltet ist.

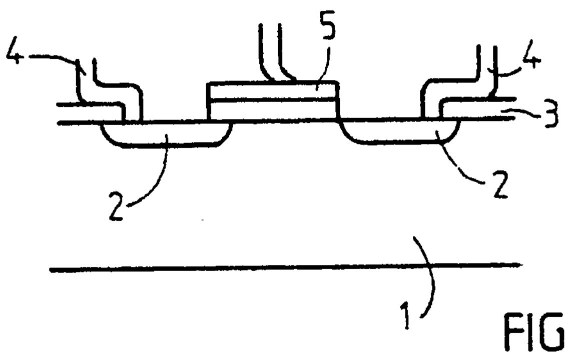


FIG 1

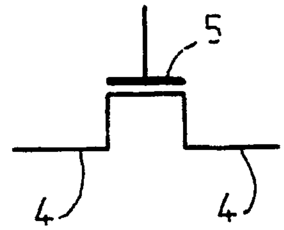


FIG. 2

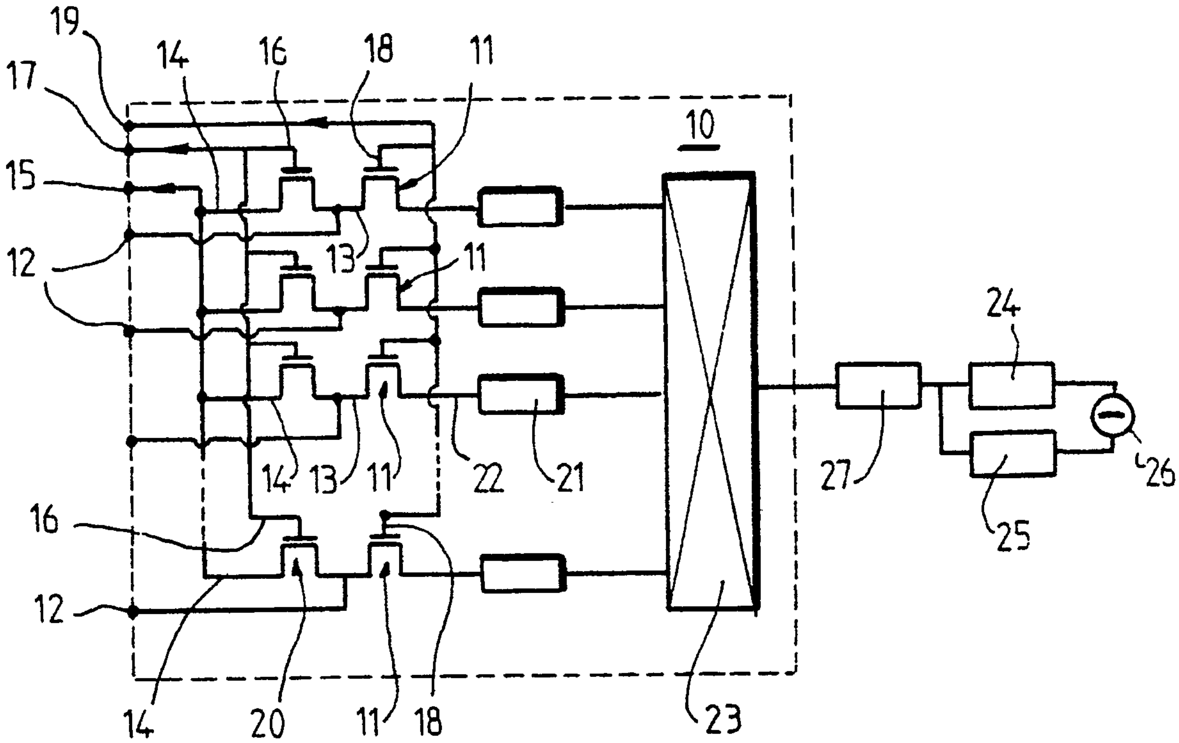


FIG. 3

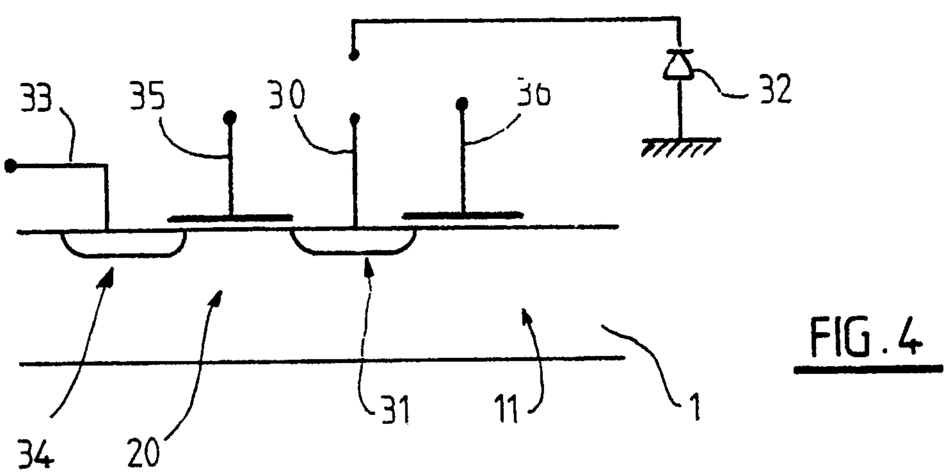


FIG. 4